# EUROPÄISCHE PATENTSCHRIFT

(11) **EP 0 838 535 B1**
(45) Veröffentlichungstag und Bekanntmachung des Hinweises auf die Patenterteilung: **02.02.2000**
(21) Anmeldenummer: 97112245.2
(22) Anmeldetag: 17.07.1997
(51) Int. Cl.: C23C 14/00, C23C 14/34, C23C 14/08

(54) **Interferenzschichtensystem**
Interference layer system
Système de couches interférentielles

(30) Priorität: 28.10.1996 DE 19644752
(43) Veröffentlichungstag der Anmeldung: 29.04.1998
(73) Patentinhaber: Leybold Systems GmbH, 63450 Hanau (DE)
(72) Erfinder: Szczyrbowski, Joachim, Dr., 63773 Goldbach (DE); Bräuer, Günter, Dr., 63579 Freigericht (DE)

(56) Entgegenhaltungen:
- WO-A-95/00677
- US-A- 4 002 545
- US-A- 4 851 095
- PATENT ABSTRACTS OF JAPAN vol. 007, no. 253 (P-235), 10.November 1983 & JP 58 137809 A (FUJITSU KK), 16.August 1983,
- FUKUSHIMA K ET AL: "ELECTRICAL PROPERTIES OF TIO2 FILMS DEPOSITED BY A REACTIVE-IONIZED CLUSTER BEAM" JOURNAL OF APPLIED PHYSICS, Bd. 65, Nr. 2, 15.Januar 1989, Seiten 619-623, XP000119020
- OKIMURA K ET AL: "CHARACTERISTICS OF RUTILE TIO2 FILMS PREPARED BY R.F. MAGNETRON SPUTTERING AT A LOW TEMPERATURE" THIN SOLID FILMS, Bd. 281/282, Nr. 1/02, 1.August 1996, Seiten 427-430, XP000643433
- PATENT ABSTRACTS OF JAPAN vol. 006, no. 067 (E-104), 28.April 1982 & JP 57 007129 A (FUJITSU LTD), 14.Januar 1982,

## Beschreibung

Die Erfindung betrifft ein Verfahren gemäß Anspruch 1 oder Anspruch 2 zur sputterinduzierten Abscheidung von Metalloxydschichten auf Substraten mittels eines reaktiven Sputterprozesses sowie ein gemäß dem Verfahren hergestelltes Schichtensystem nach Patentanspruch 3.

Gattungsgemäße Herstellungsverfahren und nach diesen Verfahren hergestellte, aus Einzelschichten bestehende Schichtensysteme sind bekannt. Mittels Sputtervorrichtung, wie sie z.B. in der DE 41 06 770 beschrieben sind, werden Substrate mit Hilfe der Kathodenzerstäubung, vorzugsweise durch Magnetronkathodenzerstäubung beschichtet, wobei sogenannte Targets der Einwirkung einer zwischen zwei Elektroden sich ausbildenden Plasmawolke ausgesetzt werden, und wobei das zerstäubte Targetmaterial, welches eine Affinität zum Reaktivgas aufweist, mit diesem auf dem Substrat eine chemische Verbindung bildend sich niederschlägt. Bei den bekannten Sputterverfahren stellt z.B. das Target die eine Elektrode und das Substrat eine zweite Elektrode dar, welche mit den beiden Ausgängen einer Stromversorgungseinrichtung elektrisch verbunden ist. Alternativ werden auch sogenannte Doppelelektroden verwendet, die wechselweise alternierend als Anode und Kathode geschaltet werden. Die elektrische Leistung wird entweder als Gleichstrom oder als Wechselstrom den Elektroden zugeführt, wie z.B. in der DE-OS-38 02 852 beschrieben.

Zur Abscheidung dielektrischer Schichten, z.B. SiO₂, Al₂O₃, ZrO₂, TiO₂, ZnO₂, besteht das zu zerstäubende Target aus der entsprechenden, in den vorgenannten Verbindungen vorliegenden Metallkomponente, auf die die Plasmawolke, welche z.B. aus einem ionisierten Ar/O₂- oder Ar/N₂-Gemisch besteht, auf das Metalltarget zerstäubend einwirkt.

Ein seit langem bekanntes Problem bei der Durchführung gattungsgemäßer Sputterverfahren besteht darin, homogene und gleichmäßig beschaffene Schichten von hoher optischer Qualität reproduzierbar für industrielle Anwendungen zur Verfügung zu stellen. So erwiesen sich die z.B. mittels DC-Sputtermode auf Glasflächen bzw. optischen Bauelementen abgeschiedenen dielektrischen Schichten, wie z.B. SiO₂, Al₂O₃ oder insbesondere auch TiO₂ als nicht wie gewünscht dauerhaft resistent gegenüber Umwelteinflüssen, wie z.B. die auf die Schichten einwirkende Luftfeuchte. Die mittels des DC-Sputtermodes realisierbaren Sputter- und Beschichtungsarten bedingen nachteilig darüber hinaus wegen der geringen Sputterraten lange und damit kostenintensive Beschichtungszeiten, während der die den Beschichtungsprozeß definierenden Verfahrensparameter stabil zu halten sind. Weiterhin erwiesen sich die optischen Eigenschaften der unter Einsatz der herkömmlichen Sputterverfahren herzustellenden Schichtsysteme den zunehmend gewachsenen Erfordernissen als nicht mehr genügend.

Aufgabe der vorliegenden Erfindung ist es, ein Verfahren zur sputterinduzierten Herstellung von Metalloxydschichten auf Substraten mittels eines reaktiven Sputterprozesses bereitzustellen, durch welches Metalloxydschichten mit hoher optischer Güte in reproduzierbarer und industriell kostengünstiger Weise herstellbar und verfügbar sind.

Erfindungsgemäß wird diese Aufgabe bei einem gattungsgemäßen verfahren der eingangs genannten Art gemäß unabhängiger Ansprüche 1 und 2 gelöst. Für Substrate, welche während des Beschichtungsprozesses vor dem Sputtertarget entlang zu verfahren sind, wie bei Anwendung in sogenannten Durchlaudanlagen, wird, wie in Anspruch 2 vorgeschlagen, eine Schichtwachstumsrate von > 40 nm m/min vorgeschlagen. Die gemäß den Verfahrensmerkmalen des Anspruchs 1 bzw. Anspruchs 2 hergestellten Metalloxydschichten weisen gegenüber herkömmlich aufgesputterten Metalloxydschichten in überraschender Weise mehrere Vorteile auf. So wurde für eine erfindungsgemäß hergestellte TiO₂ Schicht festgestellt, daß diese Brechungsindizes **n** zwischen 2,55 und 2,60 besitzen. Mittels herkömmlicher DC-Technik konnten lediglich Werte für **n** zwischen 2,35 und 2,45 erzielt werden. Für Metalloxydschichten mit hoher Brechzahl **n** bedeutet dies vorteilhaft, daß zur Erzielung einer brechzahlabhängigen Wirkung die Metalloxydschicht gegenüber herkömmlichen Metalloxydschichten dünner gefertigt sein kann. Dünner hergestellte Metalloxydschichten besitzen zudem den Vorteil, daß diese eine hohe Lichttransmission und Farbneutralität im sichtbaren Spektralbereich aufweisen. Zudem können dünne Metalloxydschichten kostengünstiger hergestellt werden als herkömmliche dicke Metalloxydschichten.

Erfindungsgemäß hergestellte Schichten weisen zudem vorteilhaft, wie in Anspruch 3 angegeben, eine sehr glatte Oberfläche auf. Die oberflächenmorphologische Struktur erfindungsgemäß hergestellter Metalloxydschichten zeigt eine sehr kompakte, kristalline Ausprägung, die eine höhere Beständigkeit gegenüber chemisch reaktiven Stoffen besitzt. Erfindungsgemäß hergestellte Metalloxydschichten sind entsprechend resistenter gegenüber Feuchteeinwirkungen als herkömmliche, z.B. mit einer DC-Plasmaentladung hergestellte Sputterschichten. Weiterhin hat sich erwiesen, daß bei Verwendung von mit Wechselspannung betriebenen Sputterplasmen die aufgetragenen TiO₂-Schichten überwiegend in einer Rutil-Struktur kristallisieren. Im Gegensatz zu der sich beim DC-Sputtern vorwiegend ausbildenden Anatas-Struktur der TiO₂-Schicht ist die Rutil-Struktur temperaturstabil bis 1855°C, wohingegen die Anatas-Struktur bei einer Temperatur von 642°C eine Phasenumwandlung durchläuft und eine nichtstabile Struktur aufweist. Weiterhin hat sich gezeigt, daß bei einem erfindungsgemäßen Verfahren bei gleicher Plasmaleistung die erzielte maximale Sputterrate etwa 6- bis 7mal höher ist als bei herkömmlichen DC-Sputterverfahren.

Erfindungsgemäß hergestellte Metalloxydschichten können zudem zur Herstellung verbesserter Low-E-Schichtensysteme sowie für sogenannte Solar-Control-Schichten mit verbesserten optischen Eigenschaften eingesetzt werden. Für Low-E-Schichten eröffnet sich vorteilhaft die Möglichkeit, auf Zinn als Targetmaterial zu Gunsten von preiswerteren Titan-Targets zu verzichten. Da die durch Sputterverfahren hergestellten SnO₂-Schichten während der Wachstumsphase nachteilig zur Inselbildung neigen, ist die Substitution von SnO₂-Schichten durch TiO₂-Schichten wünschenswert. Die bei Low-E-Schichtensystemen unmittelbar auf dem Substrat aufgetragene Grundschicht besitzt erfindungsgemäß eine glatte-, kompakt strukturierte Oberfläche, auf welche die eigentliche Low-E-Schicht, z.B. eine Silber- oder Goldschicht aufgetragen wird. Die Morphologie der erfindungsgemäß hergestellten Grundschichtoberfläche favorisiert auch vorteilhaft die Bildung einer aufgetragenen Metallschicht, die eine hohe Leitfähigkeit resp. einen niedrigen k-Wert aufweist.

Zur Herstel un erfindungsgemäßer Schichten hat sich als notwendig erwiesen, die Wechselfrequenz des das Sputterplasma versorgenden Wechselstroms zwischen 10 kHz und 80 kHz zu wählen.

Weitere vorteilhafte Verfahrensmerkmale sowie Verwendungsmöglichkeiten erfindungsgemäßer Metalloxydschichten sind in den Unteransprüchen näher charakterisiert.

Die Erfindung schließt verschiedene Ausführungsmöglichkeiten ein. Mehrere besonders vorteilhafte Ausführungsbeispiele sind in den Figuren dargestellt und werden im folgenden näher beschrieben.

Es zeigen:
- Figur 1a: eine rasterelektronenmikroskopische, REM-Abbildung der Oberfläche einer gemäß dem Stand der Technik hergestellten TiO₂-Schicht in Schrägaufsicht;
- Figur 1b: einen vergrößerten Ausschnitt der in Figur la abgebildeten TiO₂-Schicht;
- Figur 2: ein Röntgenbeugungsspektrum der in Figur 1a,1b dargestellten TiO₂-Schicht;
- Figur 3a: eine REM-Aufnahme einer TiO₂-Schicht, aufgetragen mit einer dynamischen Beschichtungsrate von 21 nm m/min und einem Betrachtungswinkel von 60° zur Oberflächennormalen;
- Figur 3b: eine REM-Aufnahme eines Querschnitts der in Figur 3a dargestellten TiO₂-Schicht;
- Figur 4: ein Röntgenbeugungsspektrum der in Figur 3a,3b abgebildeten TiO₂-Schicht;
- Figur 5a: eine REM-Abbildung einer TiO₂-Schicht, aufgetragen mit einer Beschichtungsrate von 37 nm m/min;
- Figur 5b: eine REM-Aufnahme eines Schichtquerschnittes der in Figur 5a abgebildeten TiO₂-Schicht;
- Figur 6: ein Röntgenbeugungsspektrum der in Figur 5a,5b abgebildeten TiO₂-Schicht;
- Figur 7a: eine REM-Abbildung einer durch reaktives Sputtern mit einer Schichtwachstumsrate von 49 nm m/min aufgetragenen TiO₂-Schicht;
- Figur 7b: eine REM-Schichtquerschnittsaufnahme der in Figur 7a abgebildeten TiO₂-Schicht;
- Figur 8: ein Röntgenbeugungsspektrum der in Figur 7a,7b dargestellten TiO₂-Schicht;
- Figur 9: die Kennlinie einer DC-Hochleistungskathode;
- Figur 10: die Kennlinie einer Doppelmagnetronkathode und
- Figur 11: den Leistungsverlauf und die Sputterrate gemessen als Funktion der Sondenspannung für ein erfindungsgemäßes Sputterverfahren.

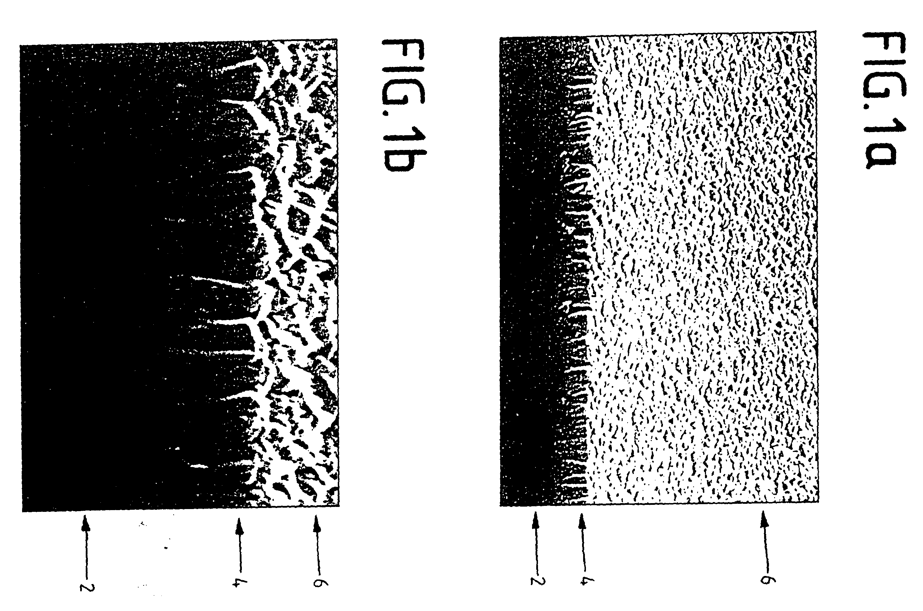

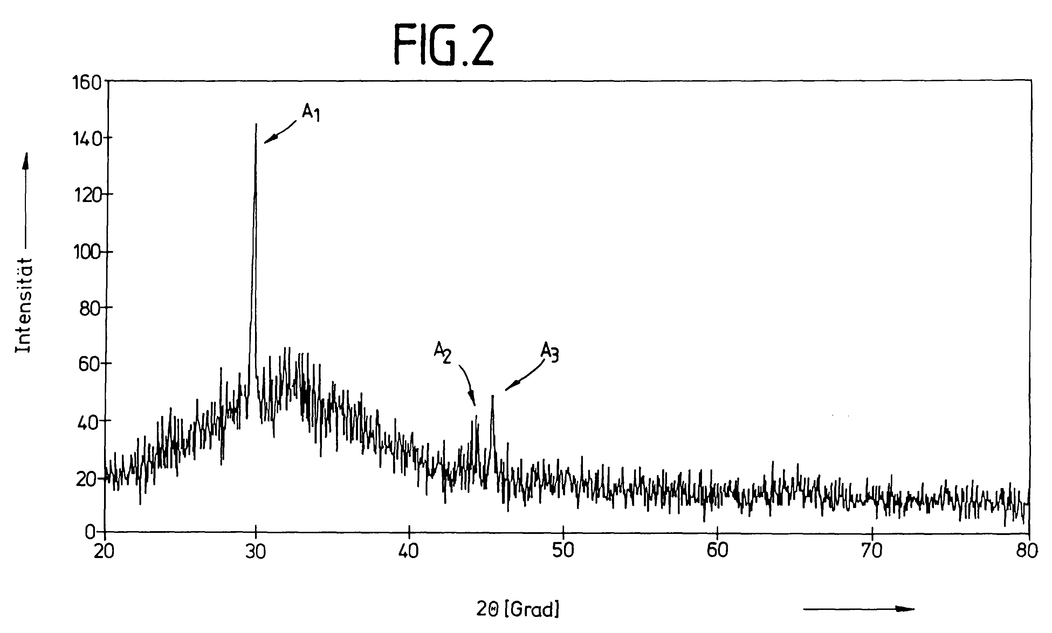

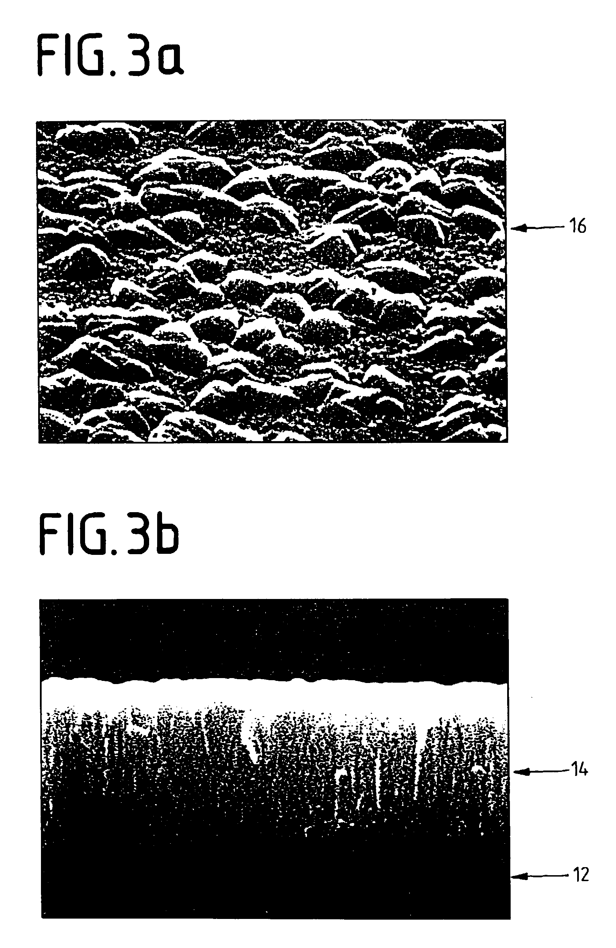

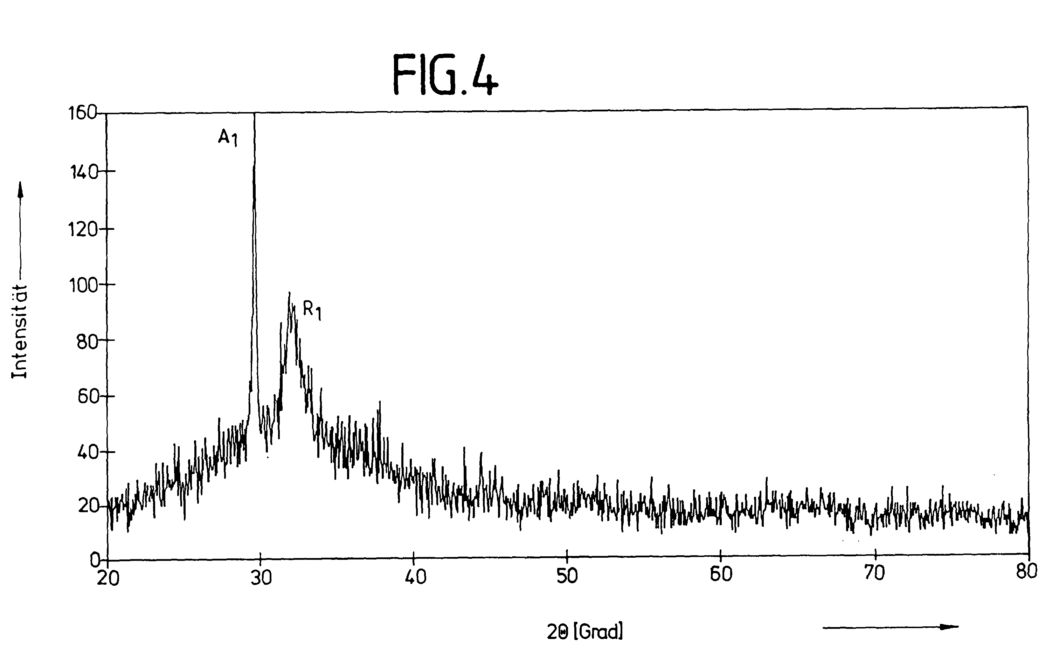

Eine mittels eines herkömmlichen DC-Sputterverfahrens hergestellte TiO₂-Schicht 4,6 ist in Figur 1a und in Figur 1b in unterschiedlichen Vergrößerungen eines REM-Bildes dargestellt. Die TiO₂-Schicht ist auf einem Si-Wafer 2 aufgetragen und weist eine Schichtdicke von ca. 500 nm auf. Die mittels des reaktiven DC-Magnetronsputterns unter Zugabe eines Ar/O₂-Gasgemisches gewachsene TiO₂-Schicht 4,6 besteht aus einzelnen, säulenformartigen Mikrokristalliten, die im wesentlichen parallel zueinander auf dem Substrat angeordnet sind. Die Oberfläche der TiO₂-Schicht 4,6 besitzt eine ausgeprägte Oberflächenrauhigkeit. Die röntgenkristallographische Analyse der in Figur 1a,1b dargestellten TiO₂-Schicht4,6 ist als Debye-Scherer-Diagramm in Figur 2 dargestellt. Die in Diagramm 2 dominierenden Beugungsreflexe A₁, A₂ und A₃ sind charakteristisch für die Anatas-Struktur von TiO₂. So stellt der Reflex A₁ die der Anatas 101, der Reflex A₂ die der Anatas 004 und Reflex A₃ die der Anatas 112 Struktur zugeordneten und die Braggsche Reflexionsbedingung erfüllenden Gitternetzebenen an.
Eine TiO₂-Schicht, hergestellt mittels eines reaktiven Sputterverfahrens bei einer Beschichtungsrate von 21 nm m/sec, wie erfindungsgemäß vorgeschlagen, ist in den Figuren 3a bzw. 3b abgebildet. Die ca. 500 nm dickeTiO₂-Schicht 14 (siehe Figur 3b) zeigt im Vergleich zu der in Figur 1b abgebildeten Schichtstruktur nur schwach ausgeprägte sowie lokal begrenzte, säulenartig gewachsene TiO₂-Mikrokristallite. Die in Figur 3a abgebildete Oberfläche 16 zeigt vereinzelt Flächenbereiche, die über eine nur geringe Rauhigkeitstiefe verfügen. Die kristalline Zusammensetzung der in den Figuren 3a,3b abgebildeten TiO₂-Schicht 14, welche auf einem Glassubstrat aufgetragen ist, ergibt sich aus dem Debye-Scherer-Diagramm (Figur 4), das neben der bekannten Anatas 101-Struktur (A₁) den Beugungsreflex R₁, der der Bragg-Reflexion an einer 110 Gitternetzebene der in Rutil-Struktur kristallisierten TiO₂-Schicht entspricht. Die Rutil-Struktur entspricht dabei den in Figur 3a auftretenden Bereichen geringer Oberflächenrauhigkeit, wohingegen die Anatas 110-Struktur zu den in Figur 3a auftretenden Inselbildungen korrespondiert.

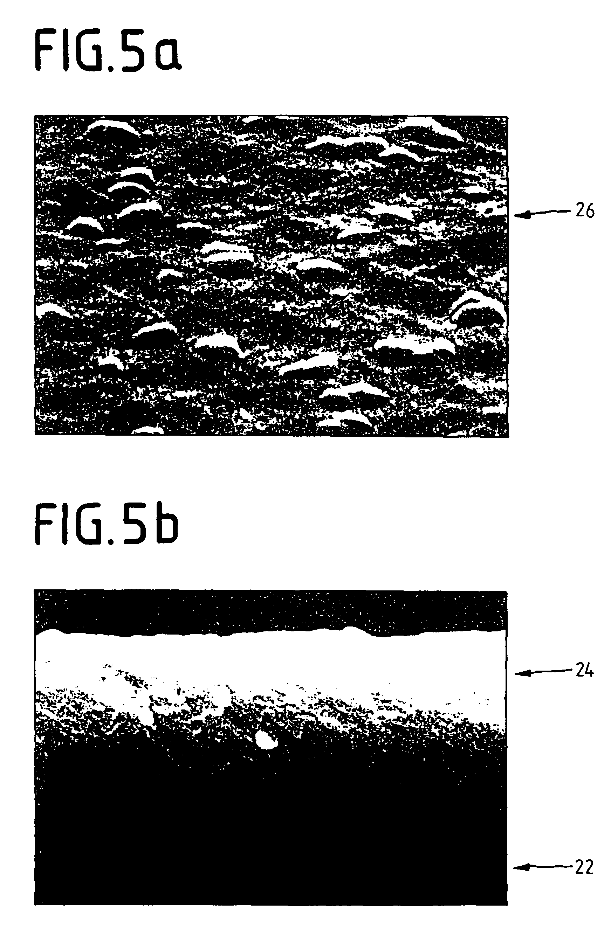

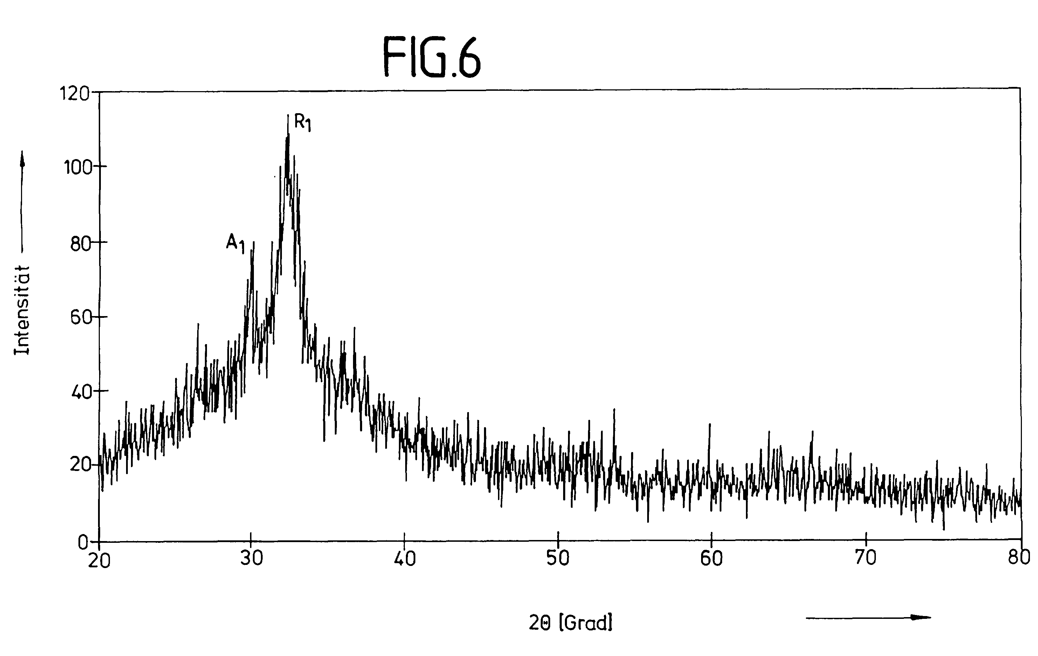

Eine TiO₂-Schicht 24, 26 aufgetragen auf ein Glassubstrat mit einer Beschichtungsrate von 37 nm m/min ist in Figur 5a abgebildet. Im Vergleich zu den in Figur 3a bzw. la dargestellten TiO₂-Oberflächen 14, 4, 6 treten bei den höheren Beschichtungsraten nur noch vereinzelt mikrokristalline Inselbildungen auf. Den mikrokristallinen Inselstrukturen entsprechende Säulenformationen sind in der in Figur 5b dargestellten Querchnittsansicht nicht mehr vorhanden. Dieses Ergebnis wird auch bestätigt durch das zugehörige Röntgenbeugungsspektrum (siehe Figur 6). So dominiert in dem zugehörigen I(2Θ)-Diagramm die Rutil 110-Struktur deutlich gegenüber der konkurrierenden Anatas 101-Struktur.

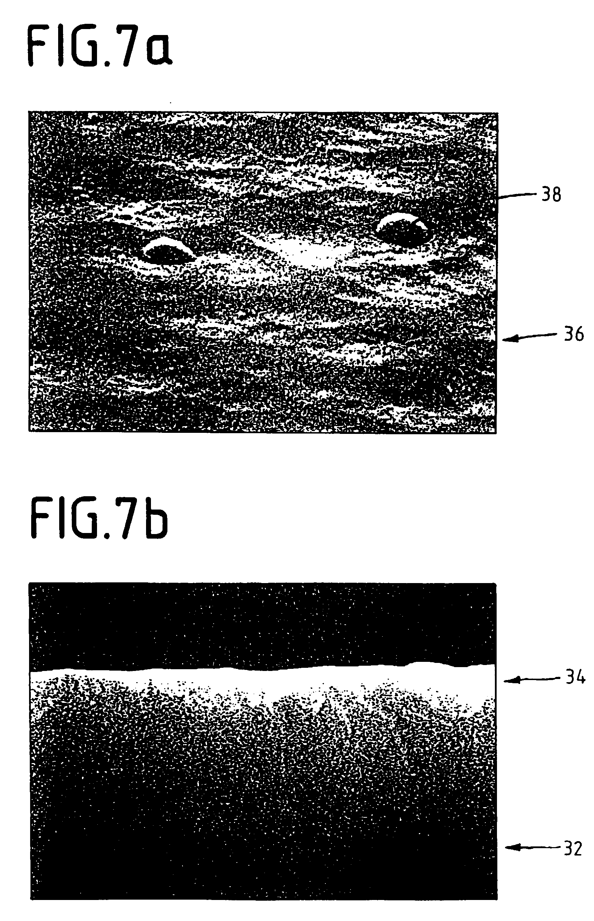

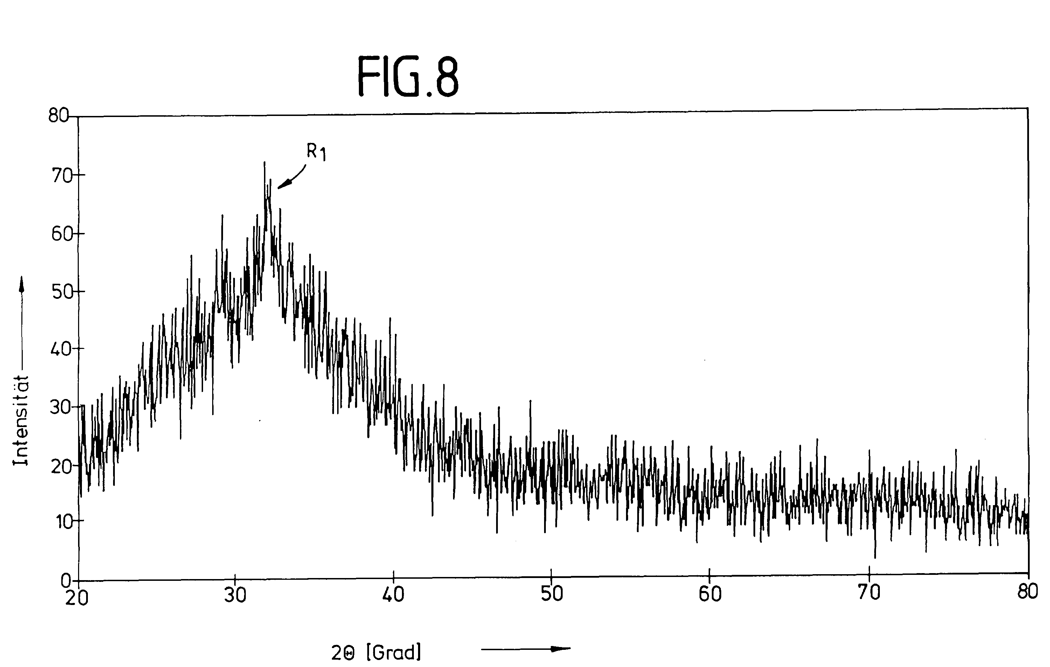

Ein noch stärkere Ausprägung der Rutil-Struktur ist in den Figuren 7a und 7b zu erkennen. Die ca. 500 nm dicke TiO₂-Schicht, aufgetragen auf einem Glassubstrat, besteht fast vollständig als Rutil-Struktur, wie aus dem zugehörigen Röntgenbeugungsspektrum in Figur 8 an Hand des allein auftretenden Rutil 110-Reflexes abzuleiten ist. Die Oberfläche 36 der mit einer Schhichtwachstumsrate von 49 nm m/min aufgetragenen TiO₂-Schicht ist nahezu homogen eben ausgeprägt und weist nur noch vereinzelte Inselbildungen 38 auf. Unter Säulenbildung wachsende Mikrokristalline Anatas-Strukturen sind in dem in Figur 7b abgebildeten Schichtquerschnitt nicht mehr zu erkennen.

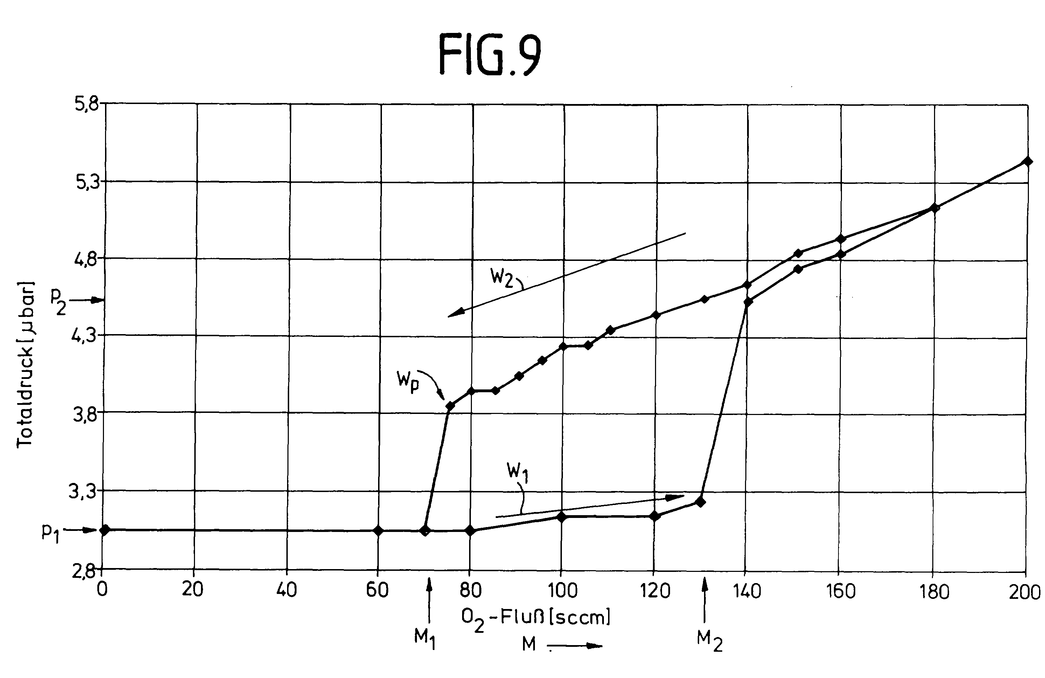

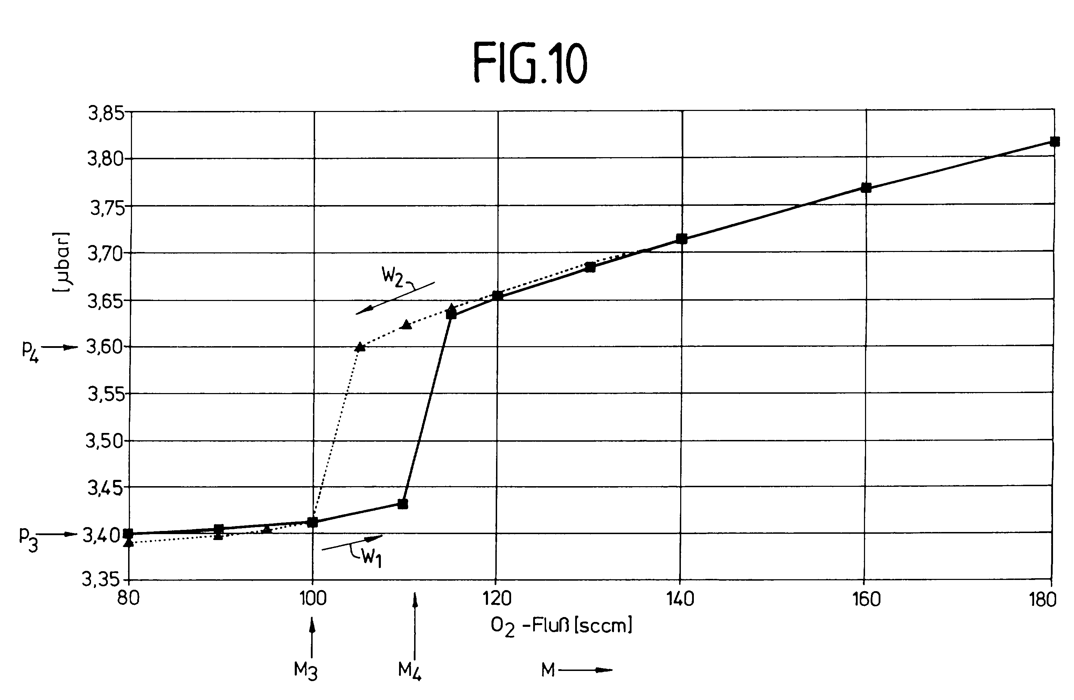

Der wesentliche Unterschied zwischen den dem Stand der Technik zu entnehmenden reaktiven Sputterverfahren und dem vorgeschlagenen erfindungsgemäßen Sputterverfahren ergibt sich aus dem Vergleich der Verläufe der zugehörigen Kathodenkennlinien eines DC-Sputterverfahrten (s. Fig. 9) und einem AC-Sputterverfahrens (Fig. 10). Figur 9 zeigt die Kennlinie einer mit Gleichstrom versorgten Hochleistungskathode, in welche ein Titan-Target integriert ist. Dargestellt ist der Totaldruck in der Sputterkammer als Funktion der in den PlasmaReaktionsraum einströmenden O₂-Gasmenge M. Die p(M)-Kennlinie weist zwischen den Arbeitspunkten M₁ und M₂ eine Hystereseschleife auf. In dem Übergangsbereich zwischen den Punkten M₁ und M₂ sind zwei Sputterzustände für die DC-Kathode möglich, nämlich ein metallischer, der auf dem Weg W₁ durchlaufen wird, und ein oxydischer Sputterzustand, der bei Durchlaufen der Hystereseschleife in Richtung W₂ vorliegt. Im Übergangsbereich zwischen M₁ und M₂ springt die mit Gleichspannung versorgte Kathode unkontrollierbar von einem Mode zum anderen. Stabile Sputterbedingungen zur Erzielung hochwertiger Metalloxydschichten sind wegen des breiten Übergangsbereichs der Hystereseschleife der in Figur 9 dargestellten p(M)-Kennlinie nur mit Hilfe aufwendiger Prozeßkontrollvorrichtungen einstellbar. Um mit einer, mit Gleichstrom versorgten Hochleistungskathode maximale Sputterraten zu erzielen, wird als Sputterarbeitspunkt ein Wert für den Sauerstoffmengenzufluß im Bereich M₁ gesucht, bei welchem die Metalloxydschichten im oxydischen Mode herstellbar sind.

Die Kennlinie einer erfindungsgemäß betriebenen, mit Wechselstrom versorgten Hochleistungsmagnetronkathode zeigt die Figur 10. Diesem Diagramm ist deutlich zu entnehmen, daß der zwischen den Arbeitspunkten M₃ und M₄ liegende Übergangsbereich nur 10 sccm breit ist und damit um einen Faktor 7 schmaler ist als bei dem herkömmlichen Sputterverfahren (siehe Figur 9).

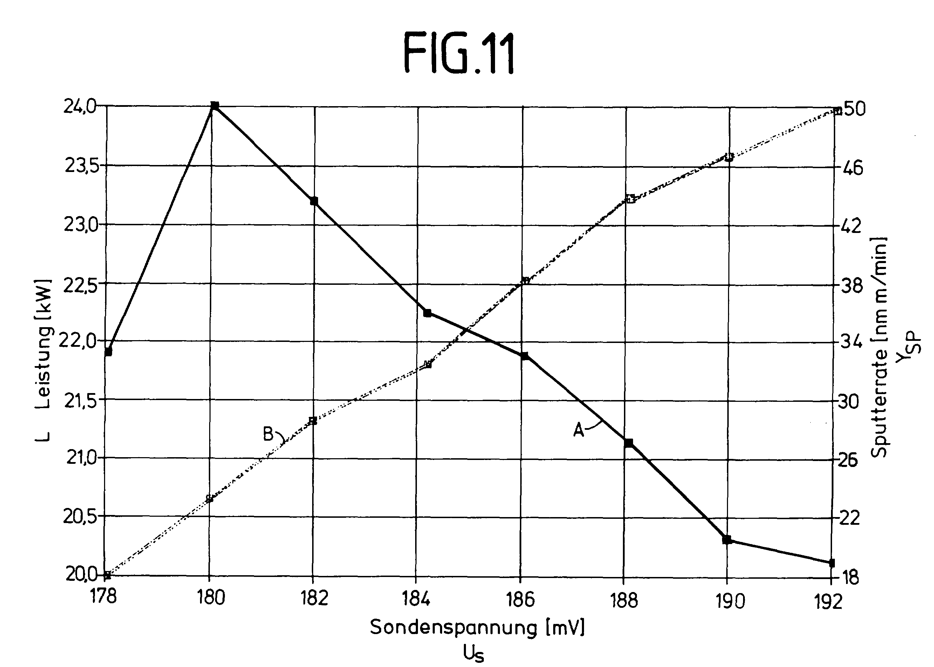

Figur 11 zeigt gemessene Sputterraten Y_{SP} und Kathodenleistung L beim konstanten Sauerstoffzufluß von 120 sccm als Funktion der Sondenspannung U_{S} für ein erfindungsgemäßes Sputterverfahren. Entsprechend dem Meßverfahren entspricht einer höheren Sondenspannung U_{S} ein geringerer Sauerstoffanteil in der Sputterkammer. Zu beobachten ist, daß je höher die Sondenspannung U_{S}, desto metallischer brennt die Kathode. Mit fallender Sauerstoffmenge steigt vorteilhaft die Sputterrate und gleichzeitig sinkt die Kathodenleistung (siehe Kurvenverlauf A). Zur Regelung des Sputterprozesses dient ein Sauerstoffsensor, der die Sondenspannung U_{S} als die einem Regelkreis zugeordnete IST-Größe bereitstellt. Wie aus Figur 11 hervorgeht, werden steigende Sputterraten Y_{SP} mit geringeren Kathodenleistungen L realisiert. Hierdurch wird die Wirtschaftlichkeit der erfindungsgemäßen Sputteranlage deutlich erhöht.

## Patentansprüche

1. Verfahren zur sputterinduzierten Abscheidung von Metalloxydschichten auf Substraten mittels eines reaktiven Sputterprozesses, **dadurch gekennzeichnet,** daß der auf das zu zerstäubende Sputtertarget einwirkenden Plasmaentladung mittels mindestens zwei benachbart zueinander im Plasmareaktionsraum angeordneter Elektroden eine elektrische Leistung zugeführt wird, die derartig gewählt wird, daß die auf dem zu beschichtenden Substrat abzuscheidenden Metalloxydschichten mit einer Schichtwachstumsrate von ≥ 4 nm/s abgeschieden werden, wobei während des Beschichtungsprozesses das zu beschichtende Substrat in Bezug zum zu zerstäubenden Targetmaterial stationär angeordnet ist, und bei dem die Elekroden mit den Ausgängen einer Wechselstromquelle elektrisch leitend verbunden sind, wobei die Wechselfrequenz der zur elektrischen Versorgung der Plasmaentladung vorgesehenen Wechselspannung zwischen 10 kHZ und 80 kHz gewählt wird.

2. Verfahren zur sputterinduzierten Abscheidung von Metalloxydschichten auf Substraten mittels eines reaktiven Sputterprozesses, **dadurch gekennzeichnet,** daß die auf dem zu beschichtenden Substrat abzuscheidenden Oxydschichten mit einer Schichtwachstumsrate von ≥ 40 nm m/min abgeschieden werden, wobei das zu beschichtende Substrat vor dem zu zerstäubenden Targetmaterial entlang verfahren wird, und bei dem die Elektroden mit den Ausgängen einer Wechselstromquelle elektrisch leitend verbunden sind, wobei die Wechselfrequenz der zur elektrischen Versorgung der Plasmaentladung vorgesehen Wechselspannung zwischen 10 kHz und 80 kHz gewählt wird.

3. Optisch wirkendes Schichtensystem, angeordnet auf Substratoberflächen und hergestellt nach mindestens einem der vorhergehenden Ansprüche, welches eine Schichtenfolge jeweils aus niederbrechendem bzw. hochbrechendem Material bestehenden Einzelschichten aufweist, wobei die einzelnen Oxydschichten auf den zu beschichtenden Substratflächen mittels eines sputterinduzierten, in einer Vakuumkammer durchgeführten Zerstäubungs- und Abscheideprozesses abgeschieden sind, und wobei das Sputterplasma mittels einer an den Plasmaelektroden anliegenden Wechselspannung versorgt wird, **dadurch gekennzeichnet,** daß der überwiegende Anteil der Oxydschicht eine Rutilstruktur aufweist und die Wechselfrequenz des die Sputterelektroden versorgenden Wechselstroms zwischen 10 kHz und 80 kHz beträgt.

4. Schichtensystem nach Anspruch 3, **dadurch gekennzeichnet,** daß die Metalloxydschichten mit einer Abscheidungsrate > 4 nm/s auf dem in Bezug zur Sputterkathode statisch angeordneten Target abgeschieden werden.

## Claims

1. Method for sputter-induced deposition of metal oxide layers on substrates by means of a reactive sputtering process, characterized in that an electrical output is supplied to the plasma discharge acting on the sputter target to be sprayed by means of at least two electrodes arranged adjacent to one another in the plasma reaction space, which output is selected such that the metal oxide layers to be deposited on the substrate to be coated are deposited at a layer growth rate of ≥ 4 nm/s, the substrate to be coated being arranged during the coating process stationarily in relation to the target material to be sprayed, and in which the electrodes are connected electrically conductively to the outputs of an alternating current source, the alternating frequency of the alternating voltage envisaged for the electrical supply to the plasma discharge being chosen between 10 kHz and 80 kHz.

2. Method for sputter-induced deposition of metal oxide layers on substrates by means of a reactive sputtering process, characterized in that the oxide layers to be deposited on the substrate to be coated are deposited at a layer growth rate of ≥ 40 nm m/min, the substrate to be coated being moved along in front of the target material to be sprayed, and in which the electrodes are connected electrically conductively to the outputs of an alternating current source, the alternating frequency of the alternating voltage envisaged for the electrical supply to the plasma discharge being chosen between 10 kHz and 80 kHz.

3. Optically acting layer system, arranged on substrate surfaces and produced according to at least one of the preceding claims, which has a layer sequence of individual layers consisting in each case of low-refracting or high- refracting material, the individual oxide layers being deposited on the substrate surfaces to be coated by means of a sputter-induced spraying and deposition process carried out in a vacuum chamber, and the sputter plasma being provided by means of an alternating voltage applied at the plasma electrodes, characterized in that the predominant part of the oxide layer has a rutile structure and the alternating frequency of the alternating current supplying the sputter electrodes comes to between 10 kHz and 80 kHz.

4. Layer system according to claim 3, characterized in that the metal oxide layers are deposited on the target arranged statically in relation to the sputter cathode at a deposition rate of > 4 nm/s.

## Revendications

1. Procédé de dépôt provoqué par pulvérisation de couches d'oxydes métalliques sur des substrats au moyen d'un processus de pulvérisation réactive, caractérisé en ce qu'une puissance électrique est appliquée à la décharge de plasma réagissant sur la cible de pulvérisation à pulvériser au moyen d'au moins deux électrodes disposées proches l'une de l'autre dans la chambre de réaction à plasma, qui est choisie de telle sorte que les couches d'oxydes métalliques à déposer sur le substrat à revêtir sont déposées avec une vitesse de croissance de couche de ≥ 4 nm/s, durant le processus de revêtement, le substrat à revêtir étant disposé stationnaire par rapport au matériau cible à pulvériser, et dans lequel des électrodes sont reliées de façon électriquement conductrice à une source de courant alternatif, la fréquence alternative de la tension alternative prévue en vue de l'alimentation électrique de la décharge de plasma étant choisie entre 10 kHz et 80 kHz.

2. Procédé de dépôt provoqué par pulvérisation de couches d'oxydes métalliques sur des substrats au moyen d'un processus de pulvérisation réactive, caractérisé en ce que les couches d'oxydes à déposer sur le substrat à revêtir sont déposées avec une vitesse de croissance de couches de ≥ 40 nm m/min, le substrat à revêtir étant déplacé devant le matériau cible à pulvériser, et dans lequel les électrodes sont reliées de façon électriquement conductrice aux sorties d'une source de courant alternatif, la fréquence alternative de la tension alternative prévue pour l'alimentation électrique de la décharge de plasma étant choisie entre 10 kHz et 80 kHz.

3. Système de couches agissant optiquement, disposé sur des surfaces de substrat et réalisé selon au moins une des revendications précédentes, qui présente une succession de couches se composant de différentes couches en matériau à faible indice de réfraction ou à fort indice de réfraction, les différentes couches d'oxyde étant disposées sur les surfaces de substrat à revêtir au moyen d'un processus de pulvérisation et de dépôt mis en oeuvre dans une chambre à vide, et le plasma de pulvérisation étant alimenté au moyen d'une tension alternative appliquée aux électrodes de plasma, caractérisé en ce que la majeure partie de la couche d'oxyde présente une structure rutile et la fréquence alternative du courant alternatif alimentant les électrodes de pulvérisation est comprise entre 10 kHz et 80 kHz.

4. Système de couches selon la revendication 3, caractérisé en ce que les couches d'oxydes métalliques sont déposées avec une vitesse de dépôt > 4 nm/s sur la cible disposée de façon stationnaire par rapport à la cathode de pulvérisation.
